# EUROPEAN PATENT APPLICATION

(11) **EP 4 255 144 A1**
(43) Date of publication of application: **04.10.2023**
(21) Application number: 20963520.0
(22) Date of filing: 27.11.2020
(51) Int. Cl.: H05K 13/00

(54) **SUBSTRATE PRODUCTION SIMULATION METHOD**

(71) Applicant: Fuji Corporation, Chiryu-shi, Aichi 472-8686 (JP)
(72) Inventor: HOTTA, Miki, Chiryu-shi, Aichi 472-8686 (JP)
(74) Representative: Grünecker Patent- und Rechtsanwälte PartG mbB
(86) International application number: PCT/JP2020/044164
(87) International publication number: WO 2022/113255

(57) **Abstract**

In a substrate production simulation method, production of a product substrate on which mounting of a component supplied from a component supply device is completed is simulated using a substrate production line including a mounting line in which multiple component mounters for mounting the component on a substrate are arranged. The method includes steps (a) to (c). In the step (a), a first result is obtained by simulation on the assumption that provision and/or collection of the component supply device with respect to the substrate production line are performed without delay. In the step (b), a second result is obtained by simulation on the assumption that the provision and/or collection of the component supply device with respect to the substrate production line is performed by an automated facility and/or a worker. In the step (c), a production delay of the second result with respect to the first result and a parameter to be a factor of the production delay included in the second result are output on the same screen.

## Description

### Technical Field

The present specification discloses a substrate production simulation method.

### Background Art

Conventionally, as a production simulation method, a method disclosed in Patent Literature 1 is known. In the method of Patent Literature 1, a computer simulates and calculates a layout of multiple processing devices in a production area, a movement of multiple conveyance means, and a load caused by an arrangement of personnel of an operator. In this simulation calculation, a load factor, throughput, a device operating ratio, and the like of the operator are calculated. According to this method, in the formulation of the layout, it is possible to design the layout in consideration of the number and arrangement of the operators. As a method for managing a production step, a method disclosed in Patent Literature 2 is known. In the method of Patent Literature 2, when start of a target operation is detected, the presence or absence of a delay in the target operation is determined based on target operation information reflecting production scheduled information and an actual operation amount specified from an operation result detected for the target operation before end of the target operation is detected.

### Patent Literature

Patent Literature 1: JP-A-2005-100092
Patent Literature 2: JP-A-2020-13388

### Summary of the Invention

### Technical Problem

However, in the method of Patent Literature 1, the load factor, the throughput, the device operating ratio, and the like of the operator are calculated, but delay in process by the operation of the operator cannot be grasped. Meanwhile, the method of Patent Literature 2 determines a delay of an actual operation with respect to a production plan, but does not simulate a delay of process by the operation of the operator with respect to the production plan. Therefore, it is not possible to estimate a factor of the production delay.

The present disclosure has been made to solve the above-described problems, and an object thereof is to easily estimate a factor of a production delay in a substrate production simulation method.

### Solution to Problem

According to an aspect of the present disclosure, there is provided a substrate production simulation method of simulating production of a product substrate on which mounting of a component supplied from a component supply device is completed using a substrate production line including a mounting line in which multiple component mounters for mounting the component on a substrate are arranged along a conveyance direction of the substrate, the substrate production simulation method including:
(a) a step of obtaining a first result by simulating production of multiple types of the product substrates by the substrate production line on an assumption that provision and collection of the component supply device with respect to the substrate production line are performed without delay;
(b) a step of obtaining a second result by simulating the production of the multiple types of product substrates by the substrate production line on an assumption that provision and/or collection of the component supply device with respect to the substrate production line is performed by an automated facility and/or a worker; and
(c) a step of outputting a production delay related display in which a production delay of the second result with respect to the first result is displayed in association with the product substrate, and a parameter related display in which a parameter to be a factor of the production delay included in the second result is displayed in association with the product substrate on the same screen.

In this substrate production simulation method, the first result is a result obtained by simulating the production of multiple types of product substrates by the substrate production line on the assumption that the provision and collection of the component supply device with respect to the substrate production line are performed without delay. The second result is a result obtained by simulating the production of multiple types of product substrates by the substrate production line on the assumption that the provision and/or collection of the component supply device with respect to the substrate production line is performed by the automated facility and/or the worker. Then, the production delay related display in which the production delay of the second result with respect to the first result is displayed in association with the product substrate, and the parameter related display in which the parameter to be the factor of the production delay included in the second result is displayed in association with the product substrate are output on the same screen. Therefore, by looking at the output screen, the factor of the production delay can be easily estimated from a change in the parameter related display at a time point when the production delay occurred or before and after the time point.

In addition, in the step (c), in a case where the production delay and the parameter to be the factor of the production delay are displayed in association with the product substrate, the production delay and parameter may be displayed in association with a timing of the operation of the provision and/or collection of the component supply device with respect to the substrate production line, or may be displayed in association with an operation interval of the provision and/or collection of the component supply device with respect to the substrate production line. The timing of the operation and the operation interval are determined in association with the product substrate.

### Brief Description of Drawings

Fig. 1 is a configuration diagram schematically illustrating substrate production floor F.
Fig. 2 is a perspective view schematically illustrating substrate production line 10.
Fig. 3 is a perspective view schematically illustrating component mounter 20.
Fig. 4 is a block diagram illustrating a configuration related to control of substrate production line 10.
Fig. 5 is a flowchart of a first simulation.
Fig. 6 is a graph illustrating a result of the first simulation.
Fig. 7 is a flowchart of a second simulation.
Fig. 8 is an explanatory diagram illustrating a state in which graphs indicating results of the first and second simulations are displayed on the same screen.
Fig. 9 is a flowchart of a simulation result display routine.
Fig. 10 illustrates an example of a graph illustrating a load factor and a production delay of an operation for each term.
Fig. 11 illustrates an example of a graph illustrating a mounting line operating ratio and a production delay for each term.
Fig. 12 illustrates an example of a graph illustrating a load distribution and the production delay of a worker for each term.
Fig. 13 illustrates an example of a graph illustrating the load factor and the production delay of an operation for each term.
Fig. 14 illustrates an example of a graph illustrating the mounting line operating ratio and the production delay for each term.
Fig. 15 illustrates an example of a graph indicating the load distribution and the production delay of a worker for each term.

### Description of Embodiments

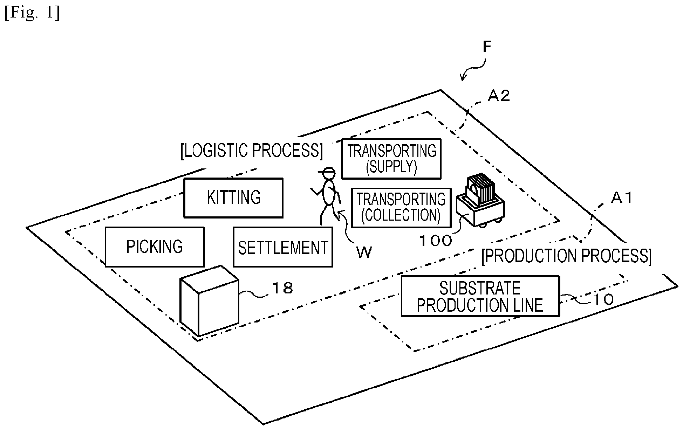

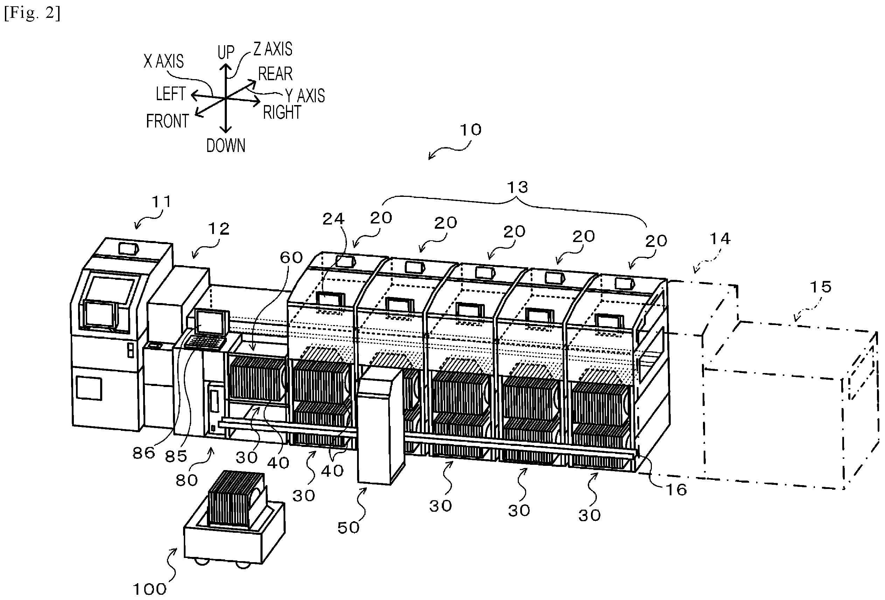

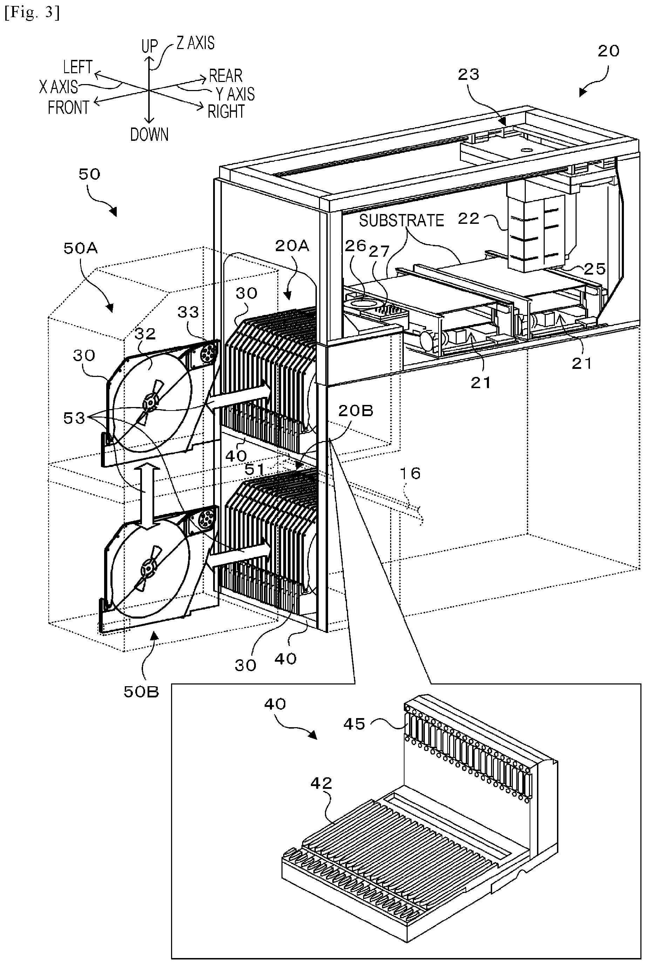

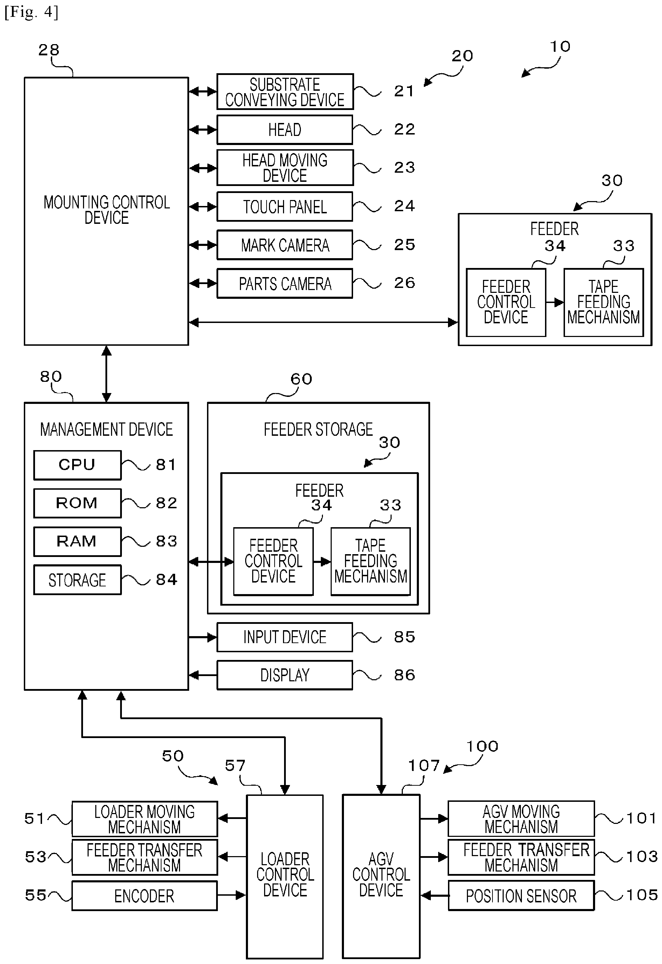

Next, an embodiment of a substrate production simulation method of the present disclosure will be described with reference to the drawings. Fig. 1 is a configuration diagram schematically illustrating substrate production floor F, Fig. 2 is a perspective view schematically illustrating substrate production line 10, Fig. 3 is a perspective view schematically illustrating component mounter 20, and Fig. 4 is a block diagram illustrating a configuration related to control of substrate production line 10. In the present embodiment, a right-left direction (X axis), a front-rear direction (Y axis), and an up-down direction (Z axis) are as illustrated in Figs. 2 and 3.

As illustrated in Fig. 1, substrate production floor F includes first area A1 and second area A2. First area A1 is an area for performing a production process. In first area A1, substrate production line 10 for producing a product (product substrate) obtained by mounting a large number of components on a substrate and soldering a substrate is provided. Second area A2 is an area for performing a logistic process. Component storage warehouse 18, feeder storage location (not illustrated), and the like are disposed in second area A2. Worker W basically performs the logistic process in second area A2.

A production process is a process for producing the product (product substrate) in which a large number of components are mounted and soldered using substrate production line 10.

The logistic process includes picking, kitting, transporting (supplying), transporting (collecting), settlement, and the like. The picking is an operation for taking out a reel for holding components necessary for a production job from component storage warehouse 18. The kitting is an operation of setting the reel in a feeder. The transporting (supplying) is an operation for transporting the kitted feeder from second area A2 to substrate production line 10 of first area A1. The transporting (collecting) is an operation of collecting the feeder used in the production job is finished or the feeder with empty components and transporting the feeders from substrate production line 10 of first area A1 to second area A2. The settlement is an operation which removes the reel with emptied component from the feeder and discards the reel, uses the feeder in which a component that can be used in a later production job remains, or detaches the reel that holds a component that is not used in a later production job from the feeder and returns the reel to component storage warehouse 18. The logistic process may be performed by an automated facility as well as by worker W. Examples of the automated facility include an automatic warehouse and an automated guided vehicle (AGV 100). The automatic warehouse is used as component storage warehouse 18, and automatically delivers necessary components. AGV 100 is a vehicle for automatically transporting a feeder or the like, and travels between first area A1 and second area A2.

As illustrated in Fig. 2, substrate production line 10 includes printing device 11, print inspection device 12, mounting line 13, appearance inspection device 14, reflow furnace 15, feeder storage 60, and management device 80. These constitute substrate production line 10 by aligning them in a conveyance direction (X-direction) of the substrate. Printing device 11 is a device for printing solder on the substrate. Print inspection device 12 is a device for inspecting the state of the solder printed by printing device 11. Mounting line 13 is configured such that multiple component mounters 20 are arranged along a conveyance direction of the substrate. Component mounter 20 is a device that takes out component supplied from feeder 30 and mounts the component on a substrate. Appearance inspection device 14 is a device for inspecting a mounting state of the component mounted by component mounter 20. Reflow furnace 15 melts solder on the substrate by heating the substrate on which a large number of components are mounted, thereby performing solder bonding. The substrate discharged from reflow furnace 15 is a product (product substrate) on which a large number of components are mounted and soldered. Feeder storage 60 is incorporated in substrate production line 10 to store feeder 30 to be used and used feeder 30 in each component mounter 20. Management device 80 manages entire substrate production line 10. Substrate production line 10 also includes loader 50. Loader 50 is movable along X-axis rail 16, so that feeder 30 can be automatically exchanged between component mounter 20 and loader 50 or between feeder storage 60 and loader 50.

As illustrated in Fig. 3, component mounter 20 includes substrate conveyance device 21 that conveys the substrate in the X-direction, head 22 that has a nozzle for picking up the component supplied by feeder 30, head moving mechanism 23 for moving head 22 in the XY directions, and touch panel display 24 (refer to Fig. 2) for performing touch input and screen output. In addition to the above, component mounter 20 includes mark camera 25, parts camera 26, nozzle station 27, and the like. Mark camera 25 images a reference mark attached to a substrate from above in order to detect the position of the substrate. Parts camera 26 images the component picked up by the nozzle provided in head 22 from below in order to detect a pick-up error or a pick-up deviation. Nozzle station 27 accommodates multiple types of nozzles that can be exchanged according to the type of component to be picked up. In addition, component mounter 20 includes mounting control device 28 (refer to Fig. 4) having a well-known CPU, ROM, RAM, or the like. Mounting control device 28 controls entire component mounter 20. Mounting control device 28 can input and output a signal to and from substrate conveyance device 21, head 22, head moving mechanism 23, touch panel display 24, mark camera 25, parts camera 26, and the like. In addition, component mounter 20 has two upper and lower areas to which feeders 30 can be attached at a front part thereof. The upper area is supply area 20A to which feeder 30 can supply the component, and the lower area is stock area 20B in which feeder 30 can be stocked. Feeder base 40 formed in an L-shape in a side view, is provided in supply area 20A and stock area 20B. Multiple feeders 30 are attached to each feeder base 40.

Feeder 30 is a kind of component supply device and is configured as a tape feeder for feeding out tapes for accommodating components at a predetermined pitch, as illustrated in Fig. 3. Feeder 30 includes tape reel 32 around which a tape is wound, tape feeding mechanism 33 for feeding out the tape from tape reel 32, and feeder control device 34 (refer to Fig. 4). Feeder base 40 includes multiple slots 42 arranged in the X-direction at an interval into which feeder 30 can be inserted. When feeder 30 is inserted into slot 42 of feeder base 40, a connector (not illustrated) of feeder 30 is connected to connector 45 of feeder base 40. As a result, feeder control device 34 can communicate with the control section (mounting control device 28, management device 80, or the like) of an attachment destination of feeder 30. Feeder control device 34 feeds the component accommodated in the tape to a predetermined component supply position by tape feeding mechanism 33, and when the component at the component supply position is picked up by the nozzle of head 22, feeder control device 34 feeds the component accommodated in the tape to a predetermined component supply position again by tape feeding mechanism 33.

As illustrated in Fig. 2, loader 50 is movable along X-axis rail 16 provided in parallel to the conveyance direction (X-direction) of the substrate on the front faces of multiple component mounters 20 and the front face of feeder storage 60. As illustrated in Figs. 3 and 4, loader 50 includes loader moving mechanism 51 and feeder transfer mechanism 53. Loader moving mechanism 51 moves loader 50 along X-axis rail 16. Feeder transfer mechanism 53 is configured to attach feeder 30 to component mounter 20 or feeder storage 60 from loader 50, detach feeder 30 from component mounter 20 or feeder storage 60 to accommodate feeder 30 in loader 50, and move feeder 30 between upper transfer area 50A and lower transfer area 50B. As illustrated in Fig. 4, loader 50 also includes encoder 55 and loader control device 57. Encoder 55 detects a movement position of loader 50 in the X-direction. Loader control device 57 includes well-known CPU, ROM, RAM, and the like. Loader control device 57 inputs a detection signal from encoder 55 and outputs a drive signal to loader moving mechanism 51 and feeder transfer mechanism 53.

Feeder storage 60 has feeder base 40 having the same configuration as that of feeder base 40 provided in component mounter 20 in order to accommodate multiple feeders 30.

AGV 100 is one of the automated facilities responsible for logistic processes (particularly transporting). AGV 100 replenishes feeder 30 on which the components necessary for production are mounted in feeder storage 60 or collects used feeder 30 from feeder storage 60 while moving between feeder storage 60 of first area A1 and component storage warehouse 18 of second area A2. As illustrated in Fig. 4, AGV 100 includes AGV moving mechanism 101 and feeder transfer mechanism 103. AGV moving mechanism 101 is for traveling AGV 100 along a predetermined traveling route, and includes a motor for traveling and a steering device. Feeder transfer mechanism 103 is a device similar to feeder transfer mechanism 53 of above-described loader 50, and can automatically exchange feeder 30 between feeder storage 60 and feeder transfer mechanism 103 or between component storage warehouse 18 and feeder transfer mechanism 103. As illustrated in Fig. 4, AGV 100 also includes position sensor 105 and AGV control device 107. Position sensor 105 detects a traveling position of AGV 100. AGV control device 107 includes a well-known CPU, a ROM, a RAM, and the like. AGV control device 107 inputs a detection signal from position sensor 105, and outputs a drive signal to AGV moving mechanism 101 or feeder transfer mechanism 103.

As illustrated in Fig. 4, management device 80 includes a well-known CPU 81, ROM 82, RAM 83, a storage (HDD or SSD) 84, and the like, and is connected to input device 85 such as a keyboard or a mouse, or display 86 such as an LCD. Management device 80 is connected to mounting control device 28, loader control device 57, and AGV control device 107 so as to be capable of bidirectional communication. Management device 80 receives information on a mounting status of component mounter 20 from mounting control device 28, receives information on a driving status of loader 50 from loader control device 57, and receives information on a driving status of AGV 100 from AGV control device 107. Management device 80 transmits a command signal relating to the mounting to mounting control device 28, transmits a command signal relating to loader 50 to loader control device 57, and transmits a command signal relating to AGV 100 to AGV control device 107. Management device 80 is communicably connected to feeder control device 34 of feeder 30 stored in feeder storage 60, so that the information of stored feeder 30 can be acquired. Management device 80 stores the production plan in storage 84. The production plan includes production information, a production target, and the like. The production information includes information on a component necessary for manufacturing a product substrate, information on a target number of products for manufacturing a product substrate, and the like. The production plan includes a plan to produce multiple types of product substrates. Therefore, the production information is stored for each type of the product substrate. The production target includes a target production time required for executing the production plan or the like.

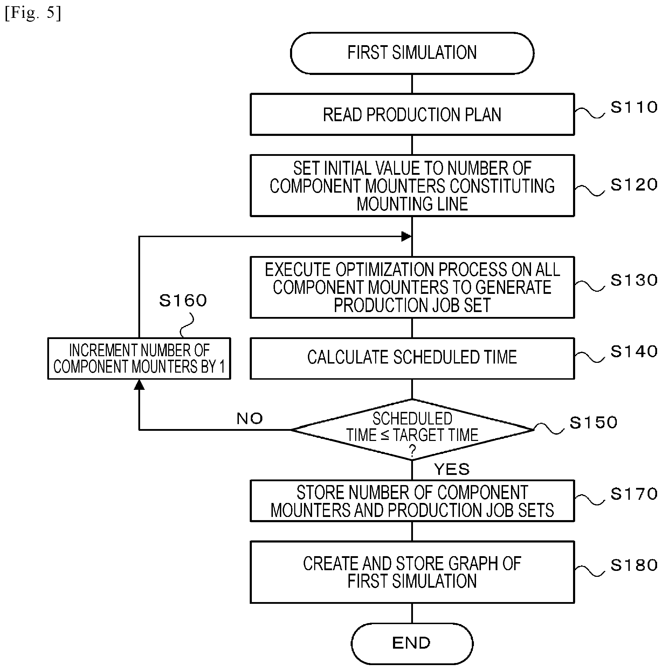

Next, a first simulation performed by management device 80 will be described. The first simulation is a simulation executed on the assumption that the provision and collection of feeder 30 with respect to mounting line 13 are performed without delay. Fig. 5 is a flowchart of the first simulation. In the first simulation, when various product substrates are continuously produced, a production job to be applied to each component mounter 20 is optimized so that the production efficiency in mounting line 13 is as high as possible, and the number of component mounters 20 constituting mounting line 13 is set so as to meet the production target. The production job is a job in which, for each component mounter 20, which feeder 30 is set in feeder base 40 in what order, and which component type of component is mounted on substrate in what order, and the like are determined.

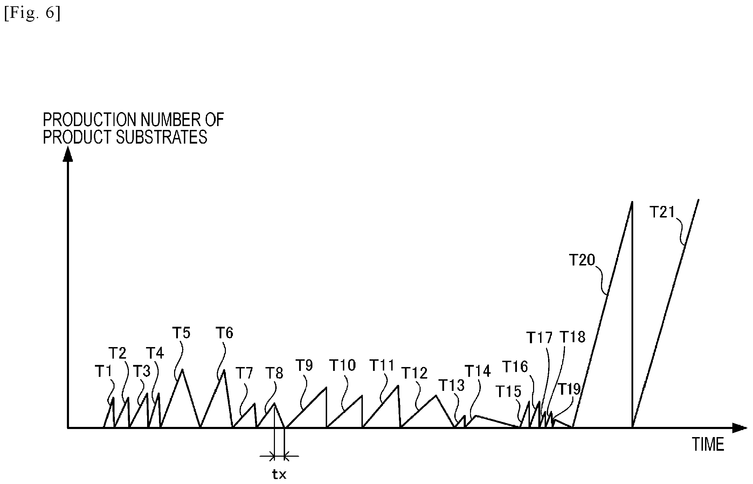

When the first simulation is started, CPU 81 of management device 80 reads the current production plan from storage 84 (S110). Next, CPU 81 sets a predetermined initial value (for example, 4) to the number of component mounters constituting mounting line 13 (S120). Next, CPU 81 executes an optimization process on all component mounters 20 constituting mounting line 13 to generate a production job set (including production jobs of all component mounters 20) (S130). In this case, it is assumed that various product substrates are subsequently manufactured by each target number of substrates. Therefore, the production job set is generated for each type of the product substrate. Next, CPU 81 calculates a scheduled production time required to execute the current production plan (S140). In calculating the scheduled production time, CPU 81 calculates the scheduled production time in consideration of the operation time of loader 50 if the exchange operation of feeder 30 by loader 50 is necessary when the manufacturing of the next type of product substrate starts after the target number of product substrates having a certain type is manufactured. Next, CPU 81 determines whether the scheduled production time is within the target production time (S150), and when the scheduled production time exceeds the target production time, the number of component mounters 20 constituting mounting line 13 is incremented by 1 (S160), and the process returns to S130 again. Meanwhile, when the scheduled production time is within the target production time in S150, CPU 81 stores the number of component mounters 20 at that time and the optimized production job set in storage 84 (S170). Thereafter, CPU 81 creates a graph (refer to Fig. 6) indicating the transition of the production number of product substrates with respect to time based on the result obtained in S170, stores the graph in storage 84 (S180), and finishes the simulation.

Here, an optimization process of the production job set in a case where a certain type of product substrate is manufactured will be described. CPU 81 finds a production job set in which a scheduled processing time (scheduled cycle time) of the production job in each component mounter 20 falls within a predetermined allowable range and a production time in mounting line 13 is minimized. In generating the production job, CPU 81 sets a mounting sequence based on the production plan, allocates the mounting sequence to each component mounter 20, sets a mounting order of the components allocated for each component mounter 20, sets an arrangement method of feeders 30 for each component mounter 20, and generates production jobs of all component mounters 20. The mounting sequence is set by designating a component type, a mounting position, and a type of nozzle to be used (type of use nozzle) in the mounting order. The allocation of the mounting sequence to each component mounter 20 is performed so that the number of the mounting sequences allocated to each component mounter 20 is equal or as uniform as possible. The mounting order of the components is set so that the mounting of the component is not obstructed by the component previously mounted, for example, when the component is mounted substrate. The arrangement method of feeders 30 is set such that feeder 30 supplying the component having a large number of being mounted on substrate in each component mounter 20 is closer to the center of feeder base 40, for example. Since there are multiple mounting sequences, allocation of mounting sequences, mounting order of the allocated components, and arrangement methods of feeders 30, respectively, the combination of the production job sets becomes an enormous number. When calculating the scheduled cycle time of each component mounter 20, CPU 81 calculates the scheduled cycle time based on simulation or data stored in the past. CPU 81 finds out a production job set in which the scheduled cycle time of all component mounters 20 falls within a predetermined allowable range and the production time is minimized from among combinations of an enormous number of production job sets.

Fig. 6 is a graph illustrating the results of the first simulation, and is a graph illustrating the transition of the production number of product substrates with respect to the time in the case of manufacturing various product substrates. In Fig. 6, it is assumed that there are 21 types of product substrates such as types T1 to T21. In this graph, a large number of line segments rising to the right are present, but each line segment represents a process for producing a target number of product substrates of one type. For example, the process until a target number of product substrates of type T1 is produced is represented by the leftmost line segment rising to the right in Fig. 6. When the process is finished, the number of substrates is once reset to zero. Thereafter, the process until a target number of product substrates of type T2 is produced is represented by the second line segment rising to the right from the left in Fig. 6. In addition, although a section from the time when the target number of product substrates of type T5 is produced to the time when the product substrate of type T6 starts to be produced is a line segment that slopes downward to the right, the exchange operation of feeder 30 by loader 50 of substrate production line 10 is performed in this section.

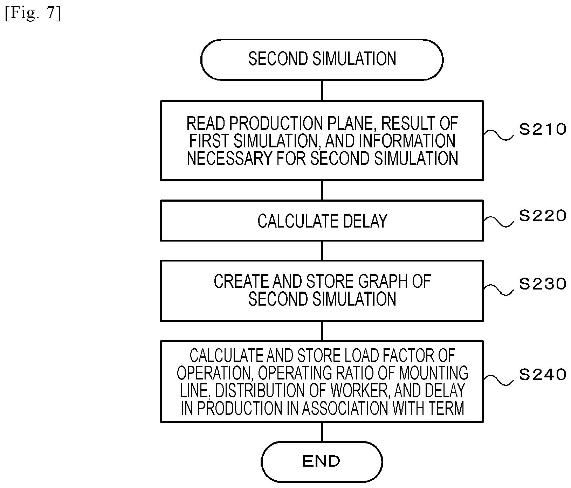

Next, a second simulation performed by management device 80 will be described. Fig. 7 is a flowchart of the second simulation. The second simulation is a simulation executed on the assumption that the provision and collection of feeder 30 with respect to mounting line 13 are performed by an automated facility (such as AGV 100 or the automatic warehouse) or worker W, and is executed after the above-described first simulation is finished. The second simulation is achieved by, for example, Plant Simulation manufactured by Siemens Corporation.

Before the second simulation is started, the operator inputs information necessary for the second simulation using input device 85. Examples of the information necessary for the second simulation include the number of workers W in charge of the logistic process, the type and the number of automated facilities, the production start time, the operation time required for picking, the operation time required for kitting, the time required for transporting, the operation time required for the post-process, or the like. Examples of the operation time required for picking include a time for taking out the component from component storage warehouse 18, a time for moving a component from a picking operation location to a kitting operation location, and the like. Examples of the operation time required for the kitting include a time for taking out feeder 30 from the feeder storage location, a time for attaching tape reel 32 to feeder 30, and the like. Examples of the time required for transporting include a transporting time for supplying feeder 30 of second area A2 to substrate production line 10 of first area A1, a transporting time for collecting feeder 30 from substrate production line 10 of first area A1 and moving feeder 30 to second area A2, and the like. Such a transporting time can be calculated from the movement speed and the movement distance of worker W when worker W performs the transporting, and can be calculated from a movement speed and a movement distance of AGV 100 when AGV 100 performs the transporting. Examples of the time required for the post-process include a time for detaching tape reel 32 from feeder 30, a time for returning feeder 30 to the feeder storage location, and the like. The information inputted by the operator is stored in storage 84.

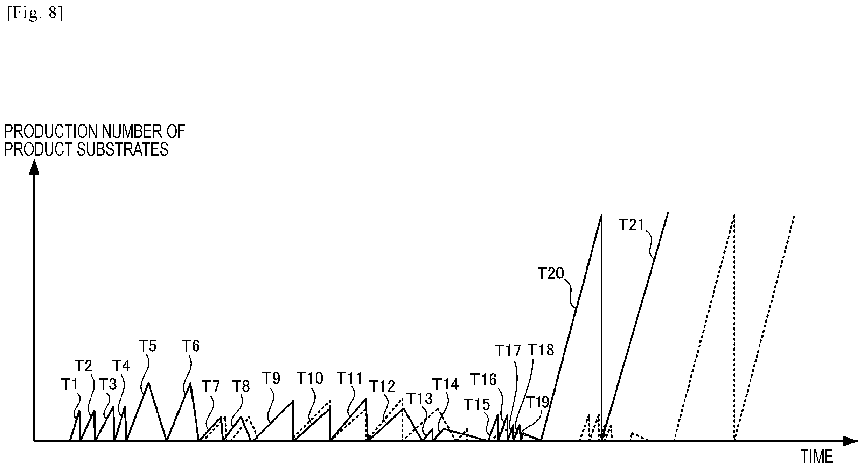

When the second simulation is started, CPU 81 of management device 80 reads the current production plan, the result (the number of component mounters 20 in mounting line 13 and the production job set) obtained in the first simulation, and the information necessary for the second simulation from storage 84 (S210). Next, CPU 81 calculates a delay caused by the provision and collection of feeder 30 with respect to mounting line 13 being performed by the automated facility or worker W (S220). The delay is calculated based on the information read in S210. For example, in the graph of Fig. 6 obtained by the first simulation, the time from the end of the production of the product substrate of type T8 to the start of the production of the product substrate of type T9 is tx. However, in a case where the number of feeders 30 requiring the exchange is large on mounting line 13, depending on the number of the workers Wand the number of the automated facilities, the picking and kitting operations in the logistic process may not be finished even after the time tx has passed since the production of the product substrate of type T8 is finished. In S220, such a delay is calculated. Next, CPU 81 creates a graph indicating the result of the second simulation and stores the graph in storage 84 (S230). Specifically, CPU 81 creates a graph taking into consideration the delay calculated in S220 based on the graph obtained in S 180 of the first simulation. Fig. 8 illustrates graphs of the first and second simulations in which the production start time is matched on coordinates having a horizontal axis of time and a vertical axis of the production number of the product substrates. In Fig. 8, solid lines represent results obtained in the first simulation, and dashed lines represent results obtained in the second simulation. According to Fig. 8, the dashed line is delayed as compared with the solid line. Next, CPU 81 calculates and stores a load factor of the operation, an operating ratio of mounting line 13, a load distribution of the worker, and a delay in production in association with the terms, respectively (S240), and finishes the present simulation.

The term is an operation interval determined for each product substrate to perform the operation necessary for providing and collecting feeder 30 with respect to substrate production line 10. The terms are numbered in accordance with the production order of the product substrate. Specifically, a term corresponding to a product substrate of a type T1 is #1, a term corresponding to a product substrate of a type T2 is #2, .... A start time and an end time of the term are calculated in S240 of the second simulation for each term. It is noted that all terms may be set to the same operation interval.

The load factor of the operation is a ratio obtained by dividing a time obtained by subtracting the start time from the end time of the term by a term scheduled time. The term scheduled time is an operation interval determined for each term and is included in the production plan. When the load factor exceeds 100%, the operation has not been completed within the term scheduled time.

The operating ratio of mounting line 13 is a ratio of time during which mounting line 13 operates to the entire term time.

The load distribution of the worker is a ratio of each worker status to the entire term time. Examples of the worker status include "during rest", "waiting", "during operation", "during movement", and the like. The "waiting" may refer to, for example, a case where the waiting is performed since the picking is not finished even when an attempt is made to perform the kitting or a case where the waiting is performed since a box (used to put feeder 30 or the like) to be placed on AGV 100 is not available.

The delay in the production is a delay in time of a result of the second simulation with respect to a result of the first simulation. The delay in the production can be calculated based on, for example, a solid line graph and a dashed line graph in Fig. 8.

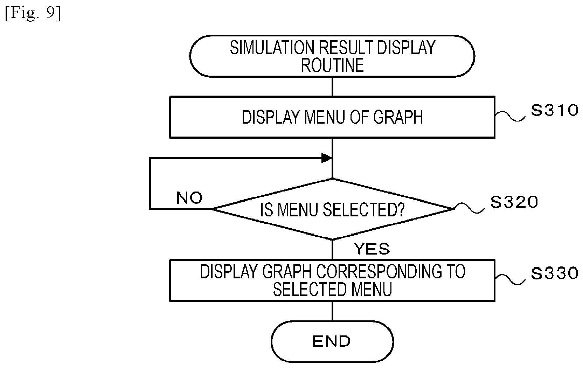

Next, the simulation result display routine executed by management device 80 will be described. Fig. 9 is a flowchart of this routine. This routine is executed when the operator instructs input device 85 to display the simulation result after the first and second simulations described above are finished. When this routine is started, CPU 81 of management device 80 displays the menu of the graph on display 86 (S310). The menu displays three graphs: (1) a graph indicating the load factor of the operation and the production delay of each term; (2) a graph indicating the operating ratio of mounting line 13 and the production delay for each term; and (3) a graph indicating the load distribution of the worker and the production delay for each term. Next, CPU 81 determines whether a menu is selected by the operator (S320), and waits as it is when the menu is not selected. Meanwhile, when the menu is selected in S320, CPU 81 creates a graph corresponding to the selected menu, displays the graph on display 86 (S330), and finishes the present routine.

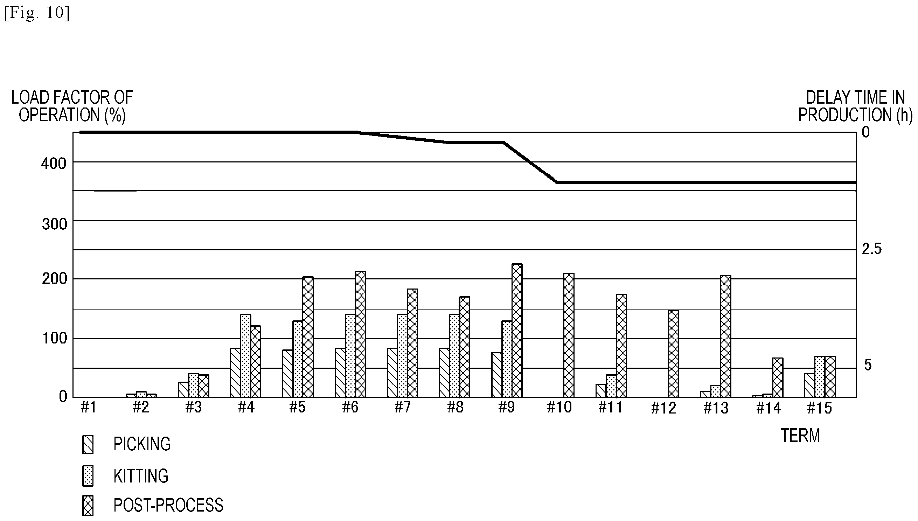

When the graph (1) indicating the load factor of the operation and the production delay of each term is selected in S320, CPU 81 displays the graph on display 86 in S330. An example of the graph is illustrated in Fig. 10. This graph is an example in which the number of workers W was one. In Fig. 10, a horizontal axis represents a term, a vertical axis on the left represents the load factor of the operation, and a vertical axis on the right represents the delay in the production. In addition, a bar graph represents the load factor of the operation (refer to the vertical axis on the left), and a line graph represents the delay (refer to the vertical axis on the right) in the production. As the operation, the picking, the kitting, and the post-process are exemplified. According to the line graph, it can be seen that the delay in the production occurred from the term #7. Looking at the load factor of the term before the term #7, it can be seen that the load factor for the kitting and the post-process exceeded 100%. Therefore, it is estimated that the reason why the delay in the production occurred in the term #7 is that the loads on the kitting and the post-process were large.

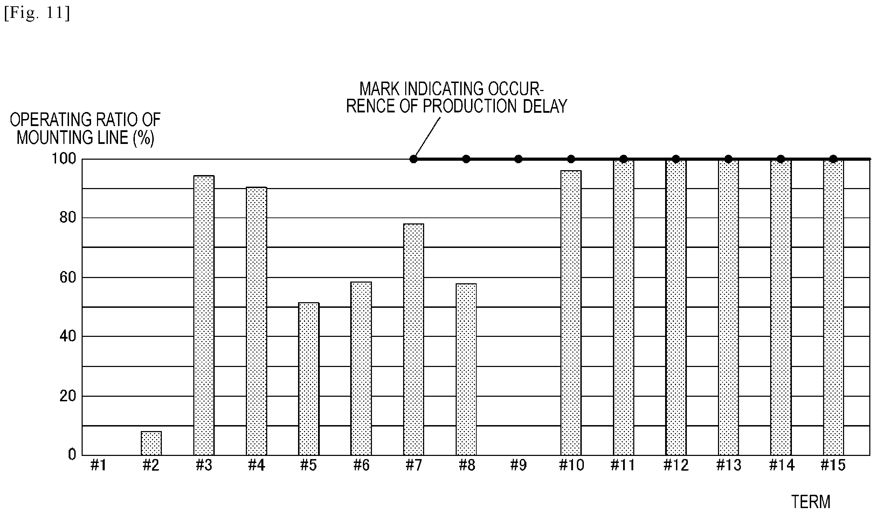

When the graph (2) indicating the operating ratio of mounting line 13 and the production delay for each term is selected in S320, CPU 81 displays the graph on display 86 in S330. An example of the graph is shown in Fig. 11. This graph is an example in which the number of workers W was one. In Fig. 11, a horizontal axis represents the term, and a vertical axis on the left represents the operating ratio of mounting line 13. In addition, a bar graph represents the operating ratio of mounting line 13, and a point graph represents the delay in the production. In the point graph, when the time delay of the second simulation with respect to the first simulation exceeds a predetermined permissible time period, a mark (black circle) indicating the occurrence of the production delay is displayed, and when the time delay is within the permissible time period, the mark is not displayed. According to the point graph, it can be seen that the delay in the production occurred from the term #7. Looking at the operating ratio of mounting line 13 of the term before the term #7, it can be seen that the operating ratios of the terms #5 and #6 were as low as about 50 to 60%. As a cause of the low operating ratios of the terms #5 and #6, it is estimated that the supply of feeder 30 to substrate production line 10 corresponding to the terms #5 and #6 might be delayed. In addition, it can be estimated that the loads of operations of the terms #5 and #6 were large so that the supply of feeder 30 to substrate production line 10 was delayed.

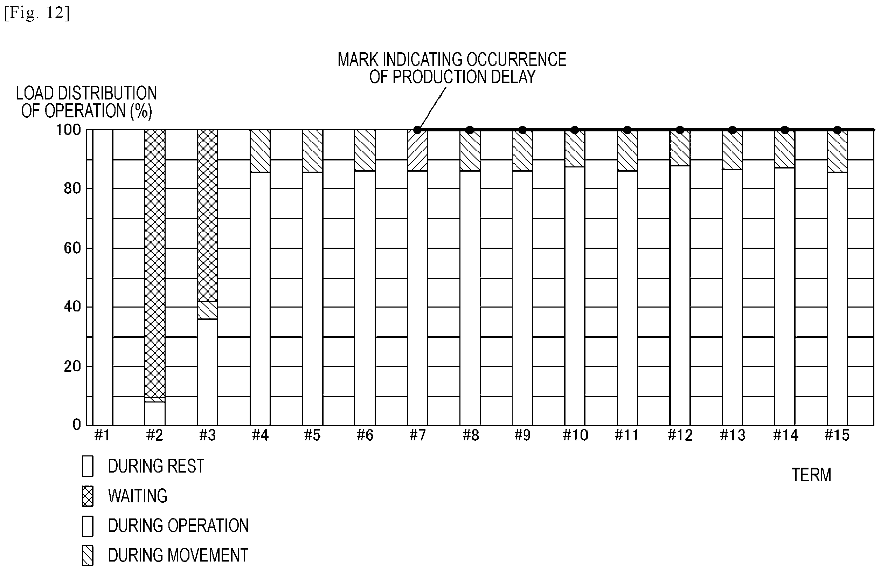

When the graph (3) indicating the load distribution and the production delay of the worker for each term is selected in S320, CPU 81 displays the graph on display 86 in S330. An example of the graph is shown in Fig. 12. This graph is an example in which the number of workers W was one. In Fig. 12, a horizontal axis represents a term, and a vertical axis on the left represents the operating ratio of mounting line 13. In addition, a bar graph represents the load distribution of the worker, and a point graph represents the delay in the production as in Fig. 11. As described above, the load distribution of the worker is a ratio of each worker status to the entire term time, and "during rest", "waiting", "during operation", and "during movement" are exemplified as the worker status. According to the point graph, it can be seen that the delay in the production occurred from the term #7. Looking at the load distribution before the term #7, it can be seen that the ratio of "during operation" was as high as about 90% in the terms #4 to #6, and the remainder was "during movement" and there is no rest. Therefore, it is estimated that the reason why the delay in the production occurred in the term #7 is that the load of the operation of the worker was large.

Figs. 10 to 12 illustrate the case in which the number of workers W was one is illustrated, and as described above, a production delay occurred. In such a case, the operator performs the second simulation again, for example, by increasing the number of workers W. Then, a simulation result display routine is executed to cause display 86 to display the graph, and this operation is repeated until the production delay is canceled.

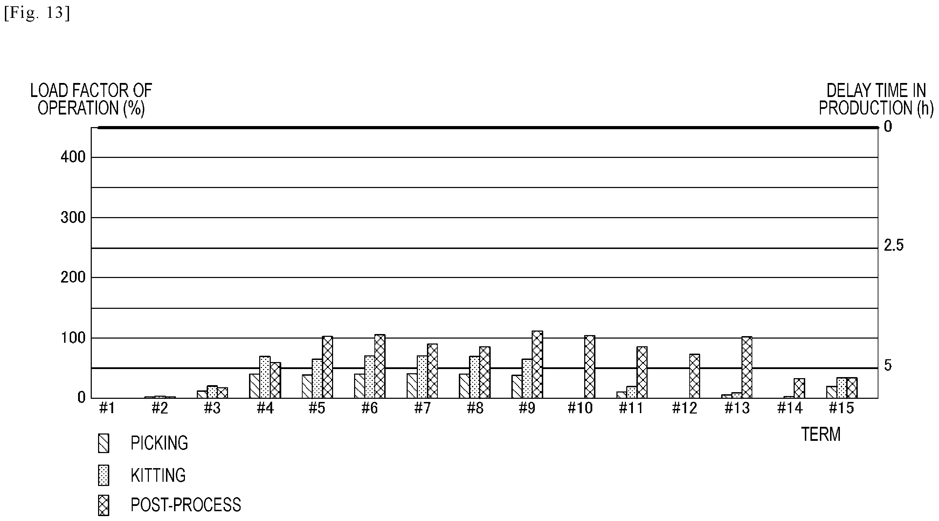

Here, a case where the second simulation is executed under the same condition as in the case where the graph display of Figs. 10 to 12 is performed except that there are two workers, and the above-described graphs (1) to (3) are displayed will be described with reference to Figs. 13 to 15.

Fig. 13 is a graph (that is, (1)) illustrating a load factor of operation and a production delay of each term in a case where there are two workers. Since the line graph shows that the time of the production delay remained zero, it can be seen that the production delay did not occur through all terms. In addition, since the production delay did not occur, it is estimated that the load factors for the picking, kitting, and post-process were reasonable throughout the entire term.

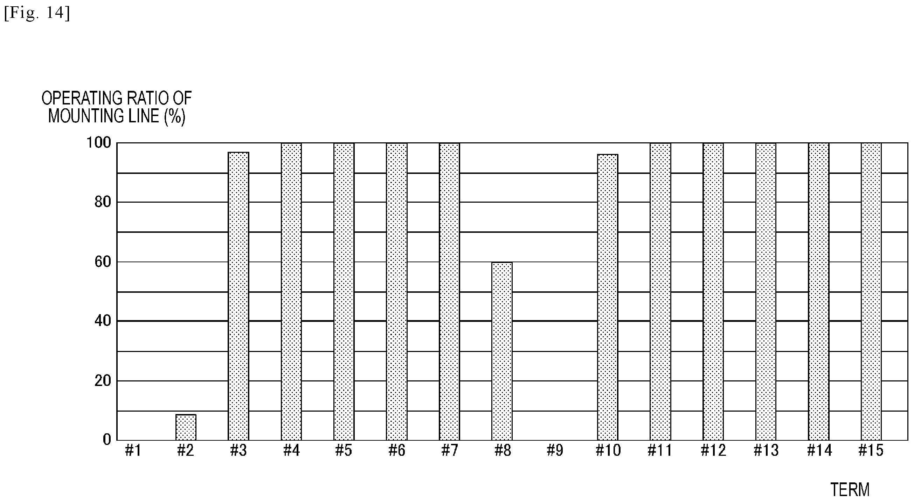

Fig. 14 is a graph (that is, (2)) illustrating the operating ratio of mounting line 13 and the production delay for each term when there are two workers. Since the point graph (a mark indicating the occurrence of the production delay) is not displayed in this graph, it can be seen that the production delay did not occur through all terms. In addition, since the production delay did not occur, it is estimated that the operating ratio of mounting line 13 was reasonable.

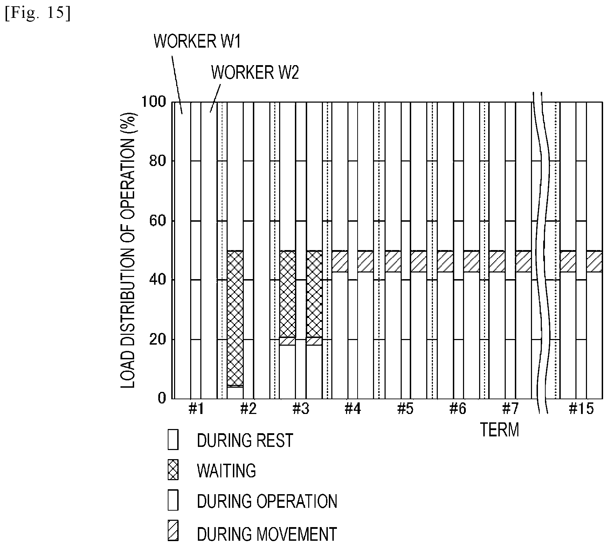

Fig. 15 is a graph (that is, (3)) illustrating the load distribution of the worker and the production delay for each term when there are two workers. In this graph, since there are two workers, two bar graphs (the load distribution of the worker W1 on the left and the load distribution of the worker W2 on the right) are displayed for one term. Since the point graph (a mark indicating the occurrence of the production delay) is not displayed in this graph, it can be seen that the production delay did not occur through all terms. In addition, since no production delay has occurred, it is estimated that the load of operation of each worker was reasonable.

Here, a correspondence between the component of the present embodiment and the component of the substrate production simulation method of the present disclosure will be clarified. The first simulation of the present embodiment corresponds to the step (a) of the present disclosure, the second simulation corresponds to the step (b), and the simulation result display routine corresponds to the step (c).

In the present embodiment described above, the result of the first simulation is a result of simulation on the assumption that the provision and collection of feeder 30 with respect to substrate production line 10 are performed without delay. The result of the second simulation is a result simulated on the assumption that the provision and/or collection of feeder 30 with respect to substrate production line 10 is performed by the automated facility and/or worker W. Then, a production delay related display (the line graph of the production delay of Fig. 10 or the point graph of Fig. 11 and Fig. 12) in which the production delay of the result of the second simulation with respect to the result of the first simulation is displayed in association with the term, and a parameter related display (the bar graph of the load factor of the operation in Fig. 10, the bar graph of the operating ratio of mounting line 13 in Fig. 11, and the bar graph of the load distribution of the worker in Fig. 12) in which the parameter to be the factor of the production delay included in the result of the second simulation is displayed in association with the term are output on the same screen. Therefore, by looking at the output screen, the factor of the production delay can be easily estimated from a change in the parameter related display at a time point when the production delay occurred or before and after the time point.

In addition, the production delay is displayed as the line graph or the occurrence of the production delay is displayed as the mark, and a parameter to be the factor of the production delay is displayed as the bar graph. Therefore, it is easy to visually recognize the presence or absence of a production delay on the screen and the change in the parameter.

Further, in Figs. 10 and 13, the load factors of the picking, kitting, and post-process (the operation relating to the provision and/or the collection of feeder 30 with respect to substrate production line 10) are adopted as the parameter to be the factor of the production delay. Therefore, from the change in the load factor of the operation at the time point when the production delay occurred or before and after the time point, it is possible to know which term the load of the operation corresponding to was large.

Furthermore, in Figs. 11 and 14, the operating ratio of mounting line 13 is adopted as the parameter to be the factor of the production delay. Therefore, from the change in the operating ratio of the mounting line at the time point when the production delay occurred or before and after the time point, it is possible to know which term the operating ratio corresponding to was low, and it can be estimated that the reason for the low operating ratio is the possibility that operation corresponding to the term was delayed.

In Figs. 12 and 15, the load distribution of the worker is adopted as the parameter to be the factor of the production delay. Therefore, from the change in the load distribution of the worker at the time point when the production delay occurred or before and after the time point, it is possible to know which term the load of the operation of the worker corresponding to was large.

It is needless to say that the present invention is not limited to the above-described embodiments, and may be practiced in various forms as long as it belongs to the technical scope of the present invention.

For example, in the above embodiment, the production delay is displayed as the line graph in Fig. 10, but the point graph (the mark indicating the occurrence of the production delay) as in Fig. 11 may be displayed in place of the line graph. In addition, in Fig. 11 and Fig. 12, the production delay is displayed as the point graph, but the line graph as in Fig. 10 may be displayed instead.

In the above embodiment, the number of workers increases in order to cancel the production delay in Figs. 10 to 12, but the number of automated facilities (that is, automatic warehouse or AGV 100) may increase in place of or in addition to this.

In the above embodiment, substrate production line 10 includes printing device 11. In this case, in the first simulation, the simulation may be performed on the assumption that the preparation operation of printing device 11 (for example, supply operation of solder paste to printing device 11, exchange operation of mask and squeegee, or the like) is performed without delay, and in the second simulation, the simulation may be performed on the assumption that the preparation operation of printing device 11 is performed by the automated facility (for example, an AGV) or worker W. The preparation operation of printing device 11 is the logistic process. In this way, it is possible to easily estimate the factor of the production delay in substrate production line 10 including printing device 11.

Substrate production line 10 of the above-described embodiment may include a substrate supplying device that supplies an unmounted substrate on which the component is not mounted to printing device 11 located on an upstream side of mounting line 13, and a substrate accommodating device that accommodates the product substrate from reflow furnace 15 located on a downstream side of mounting line 13. In the first simulation, simulation may be performed on the assumption that a mounting operation for mounting the unmounted substrate on the substrate supplying device and a taking-out operation for taking out the product substrate from the substrate accommodating device are performed without delay, and in the second simulation, simulation may be performed on the assumption that the mounting operation and the taking-out operation is performed by the automated facility (for example, AGV 100) and/or worker W. The mounting operation and the taking-out operation are logistic processes. In this way, it is possible to easily estimate the factor of the production delay in substrate production line 10 including the substrate supplying device and the substrate accommodating device.

In the above embodiment, management device 80 executes the first and second simulations, but the present invention is not particularly limited to this. For example, one computer or multiple computers other than management device 80 may execute the first and second simulations.

In the above embodiment, feeder 30 is exemplified as the component supply device, but a tray on which components are placed may be used instead of or together with feeder 30.

The substrate production simulation method of the present disclosure may be configured as follows.

In the substrate production simulation method of the present disclosure, in the step (c), the production delay related display may be a line graph or a mark indicating occurrence of the production delay, and the parameter related display may be a bar graph. In this manner, it is easy to visually recognize the presence or absence of a production delay on the screen and the change in the parameter.

In the substrate production simulation method of the present disclosure, in the step (c), the parameter to be the factor of the production delay may be a load factor of an operation relating to the provision and/or collection of the component supply device. In this case, from the change in the load factor of the operation at the time point when the production delay occurred or before and after the time point, it is possible to know which product substrate the load of the operation corresponding to was large.

In the substrate production simulation method of the present disclosure, in the step (c), the parameter to be the factor of a production delay may be an operating ratio of the mounting line included in the second result. In this case, from the change in the operating ratio of the mounting line at the time point when the production delay occurred or before and after the time point, it is possible to know which product substrate the operating ratio corresponding to was low, and it can be estimated that the reason for the low operating ratio is the possibility that operation corresponding to the product substrate was delayed.

In the substrate production simulation method of the present disclosure, in the step (c), the parameter to be the factor of the production delay may be a load distribution of the operation of the worker included in the second result. In this case, from the change in the load distribution of the operation of the worker at the time point when the production delay occurred or before and after the time point, it is possible to know which product substrate the load of the worker corresponding to was large.

The substrate production simulation method of the present disclosure may further include (d) a step of changing, when the second result is delayed with respect to the first result in the step (c), the number of the automated facilities and/or the number of the workers so that the delay of the second result is canceled and executing the step (b) and step (c) again using the changed number, and (e) a step of repeating the step (d) until the delay of the second result with respect to the first result falls within an allowable range in the step (c). In this way, it is possible to obtain the number of automated facilities and/or the number of workers in which the delay in substrate production does not occur.

### Industrial Applicability

The substrate production simulation method of the present disclosure can be used in producing a substrate on which a component is mounted.

### Reference Signs List

10: substrate production line, 11: printing device, 12: print inspection device, 13: mounting line, 14: appearance inspection device, 15: reflow furnace, 16: X-axis rail, 18: component storage warehouse, 20: component mounter, 20A: supply area, 20B: stock area, 21: substrate conveyance device, 22: head, 23: head moving mechanism, 24: touch panel display, 25: mark camera, 26: parts camera, 27: nozzle station, 28: mounting control device, 30: feeder, 32: tape reel, 33: tape feeding mechanism, 34: feeder control device, 40: feeder base, 42: slot, 45: connector, 50: loader, 50A: upper transfer area, 50B: lower transfer area, 51: loader moving mechanism, 53: feeder transfer mechanism, 55: encoder, 57: loader control device, 60: feeder storage, 80: management device, 81: CPU, 82: ROM, 83: RAM, 84: storage, 85: input device, 86: display, 100: AGV, 101: AGV moving mechanism, 103: feeder transfer mechanism, 105: position sensor, 107: AGV control device, A1: first area, A2: second area, F: substrate production floor, and W, W1, W2: worker

## Claims

1. A substrate production simulation method of simulating production of a product substrate on which mounting of a component supplied from a component supply device is completed using a substrate production line including a mounting line in which multiple component mounters for mounting the component on a substrate are arranged along a conveyance direction of the substrate, the substrate production simulation method comprising:
(a) a step of obtaining a first result by simulating production of multiple types of the product substrates by the substrate production line on an assumption that provision and collection of the component supply device with respect to the substrate production line are performed without delay;
(b) a step of obtaining a second result by simulating the production of the multiple types of product substrates by the substrate production line on an assumption that provision and/or collection of the component supply device with respect to the substrate production line is performed by an automated facility and/or a worker; and
(c) a step of outputting a production delay related display in which a production delay of the second result with respect to the first result is displayed in association with the product substrate, and a parameter related display in which a parameter to be a factor of the production delay included in the second result is displayed in association with the product substrate on the same screen.

2. The substrate production simulation method according to claim 1,
wherein in the step (c), the production delay related display is a line graph or a mark indicating occurrence of the production delay, and the parameter related display is a bar graph.

3. The substrate production simulation method according to claim 1 or 2,
wherein in the step (c), the parameter to be the factor of the production delay is a load factor of an operation relating to the provision and/or collection of the component supply device.

4. The substrate production simulation method according to claim 1 or 2,
wherein in the step (c), the parameter to be the factor of the production delay is an operating ratio of the mounting line included in the second result.

5. The substrate production simulation method according to claim 1 or 2,
wherein in the step (c), the parameter to be the factor of the production delay is a load distribution of an operation of the worker included in the second result.

6. The substrate production simulation method according to any one of claims 1 to 5, further comprising:
(d) a step of changing, when the second result is delayed with respect to the first result in the step (c), the number of the automated facilities and/or the number of the workers so that the delay of the second result is canceled and executing the step (b) and step (c) again using the changed number ; and
(e) a step of repeating the step (d) until the delay of the second result with respect to the first result falls within an allowable range in the step (c).
